Europäisches Patentamt

European Patent Office

Office européen des brevets

(11) Veröffentlichungsnummer: **0 292 590**

**A1**

## (12) EUROPÄISCHE PATENTANMELDUNG

(21) Anmeldenummer: **87107679.0**

(51) Int. Cl.4: **G01R 1/067**

(22) Anmeldetag: **26.05.87**

(43) Veröffentlichungstag der Anmeldung:
**30.11.88 Patentblatt 88/48**

(84) Benannte Vertragsstaaten:
**AT CH DE FR GB IT LI NL**

(71) Anmelder: **Feinmetall Gesellschaft mit
beschränkter Haftung
Zeppelinstrasse 2
D-7033 Herrenberg(DE)**

(72) Erfinder: **Krueger, Gustav, Dr.
Danziger Strasse 1
D-7033 Herrenberg(DE)**

(74) Vertreter: **König, Oskar, Dr.-Ing. Dipl.-Phys.
Klüpfelstrasse 6 Postfach 51
D-7000 Stuttgart 1(DE)**

(54) **Kontaktiervorrichtung für Prüfvorrichtungen.**

(57) Kontaktiervorrichtung zum Kontaktieren von elektrischen oder elektronischen Prüflingen. Sie weist eine Führungsvorrichtung auf, welche mindestens eine Ausnehmung aufweist, in der eine metallische Schraubendruckfeder angeordnet ist, an die eine gerade Schraubenfeder einstückig und axial anschließt, die über die Führungsvorrichtung übersteht und deren Windungsdrehzahl/cm größer als die Windungszahl/cm der Schraubendruckfeder ist.

FIG.2

## Kontaktiervorrichtung für Prüfvorrichtungen

Die Erfindung betrifft eine Kontaktiervorrichtung gemäß dem Oberbegriff des Anspruches 1.

Derartige Prüfvorrichtungen, für die solche Kontaktiervorrichtungen bestimmt sind, dienen der Prüfung von Prüflingen auf elektrische Fehlerfreiheit. Die Kontaktiervorrichtung hat meist viele tausende, oft sogar Millionen von Prüflingen zu kontaktieren.

Prüfvorrichtungen dieser Art sind bekannt und weisen im allgemeinen einen Prüfadapter oder dgl. mit einer Vielzahl von dem Kontaktieren von zu prüfenden integrierten Schaltkreisen, Leiterplatten oder sonstigen Prüflingen dienenden Federkontaktstiften auf, s. z.B. Krüger "Prüfmittel zur Prüfung von Leiterplatten für Uhren", Jahrbuch der Deutschen Gesellschaft für Chronometrie", Bd.30, 1979, S.269-276. Der Prüfadapter ist an das Testgerät oder den Auswerter angeschlossen, das bzw. der die Prüfung des jeweils durch den Prüfadapter kontaktierten Prüflings durchführt.

Bekannte Federkontaktstifte dieser Art (DE-OS 28 52 886; Krüger w.o.) weisen eine metallische Hülse auf, in die eine zylindrische, metallische Schraubendruckfeder eingesetzt ist, die einen in der Hülse gleitbar angeordneten Kolben eines aus der Hülse herausragenden Kontaktelementes federbelastet und sich an einem in die Hülse fest eingesetzten Bodenstück abstützt. Dieses Kontaktelement weist eine am Kolben koaxial zu ihm angeordnete Stange auf, an der ein Kontaktkopf fest angeordnet ist, welcher zum Inkontaktkommen mit den zu kontakierenden Prüflingen bestimmt ist. Derartige Federkontaktstiffte sind in der Herstellung relativ teuer. U.a. verursacht das Kontaktelement relativ hohe Kosten infolge seiner außerordentlich kleinen Durchmesser, da die Hülsen solcher Federkontaktstifte nur sehr geringe maximale durchmesser von im allgemeinen höchstens 1,5 mm aufweisen dürfen. Dagegen sind diese Federkontaktstifte zwecks ausreichend starker axialer Eigenfederung und ausreichend hohen Kontaktkräften, die meist mehr als hundert cN betragen sollen, relativ lang ausgebildet, bspw. meist ca. 1 bis 5 cm.

Es ist deshalb eine Aufgabe der Erfindung, eine Kontaktiervorrichtung der im Oberbegriff des Anspruches 1 genannten Art zu schaffen, die kostengünstiger herstellbar ist und auch besonders geringe Mittenabstände von an einem Prüfadapter oder dgl. einander benachbarter Kontaktelemente ermöglicht.

Diese Aufgabe wird erfindungsgemäß durch eine Kontaktiervorrichtung gemäß Anspruch 1 gelöst.

Die Schraubenfeder des Kontaktelementes, welche das Kontaktelement allein oder zusammen mit einem an ihm angeordneten Kontaktkopf bilden kann, ist kostengünstig in einem Arbeitsgang zusammen mit der Schraubendruckfeder durch Wickeln herstellbar, da diese Schraubenfeder und die Schraubendruckfeder eine einzige einstückige Feder bilden. Sehr vorteilhaft ist dabei auch, daß die Schraubendruckfeder außerhalb der Führung aus ihrer geraden Richtung seitlich ohne zu knicken ausgebogen werden kann, was sich beim Kontaktapritze von Prüflingen günstig auswirkt, indem bspw. dann, wenn das Kontaktelement dem Kontaktieren von zu ihm exzentrisch angeordneten Bohrungsrändern dient, sich dann das freie Kontaktende dieses Kontaktelementes in der Bohrung von selbst zentriert und hierdurch optimal sicherer Kontakt erreicht wird. Auch wird der Bohrungsrand des Prüflings gleichmäßig belastet und es besteht nicht mehr folgende Beschädigungsgefahr der bekannten, massive Kolben aufweisenden Federkontaktstifte: Wenn die Kontaktspitze des Kontaktelementes eines vorbekannten Federkontaktstiftes mit massivem Kolben exzentrisch auf einen Bohrungsrand einer Leiterplatte oder dgl. auftrifft, kann dieses Kontaktelement nicht radial ausweichen und versucht deshalb den Kolben in der Hülse schräg zu stellen mit der Folge hoher Reibung, die unter Umständen sogar zum Klemmen des Kolbens führen kann. Es besteht hierdurch Beschädigungsgefahr des Kontaktelementes bis zu seinem Brechen und es kann auch zu Überlastung des kontaktierten Bohrungsrandes der Leiterplatte oder dgl. kommen. Diese Nachteile lassen sich also durch die Erfindung auf einfache Weise vermeiden

Da das Kontaktierglied zum sicheren Kontaktieren von Prüflingen relativ große Kontaktkräfte von oft mehreren hundert cN ausüben muß, ist sein Federungsweg relativ groß vorzusehen, so daß gute Führung der Schraubenfeder in der zugeordneten Führung erforderlich ist und wegen der Genauigkeit des Kontaktierens auch enge Führung mit geringem Spiel. Dies läßt sich besonders gut dadurch erreichen, daß die Windungen der Schraubenfeder im von Prüflingen unbelasteten Zustand aneinander anliegen.

Auch ist infolge der elektrisch isolierenden Umfangswand oder -wände der das Kontaktierglied enthaltenden Führung der Führungsvorrichtung es einfacher als bisher möglich, sicherzustellen, daß zwischen den Kontaktiergliedern, die am Prüfadapter oder dgl. in meist großen Stückzahlen, bspw. zu tausenden in geringen Abständen parallel nebeneinander angeordnet sind keine elektrischen Kontakte stattfinden, und es können auch besonders geringe Mittenabstände benachbarter Kontaktierglieder erreicht werden, wie sie bisher bei Federkontaktstiften mit metallischen Hülsen nicht erreichbar waren. So können die Kontaktierglieder direkt in Ausnehmungen oder dgl. mindestens einer Platte eines Prüfadapters in bisher nicht möglichen geringen Mittenabständen nebeneinander eingesetzt werden, welche Platte oder Platten sie elektrisch gegeneinander isolieren und zu diesem Zweck vorzugsweise aus elektrisch isolierendem Kunststoff hergestellt sein können, oder es können die Umfangswände der Führungen für die Kontaktierglieder mit elektrisch isolierenden dünnen Beschichtungen versehen sein.

Auch kann die erfindungsgemäße Kontaktiervorrichtung als ein aus relativ wenigen Teilen bestehender Federkontaktstift ausgebildet sein, der im einfachsten Fall nur aus der Hülse und der eine einstückige Feder bildenden Schraubendruckfeder und Schraubenfeder besteht, also nur aus zwei Teilen zu bestehen braucht.

Das rückwärtige Ende der Schraubendruckfeder kann in der Führungsvorrichtung fest angeordnet sein. Es ist jedoch auch möglich, in ihr ein Auflager für das rückwärtige Ende der Schraubendruckfeder anzuordnen, das zweckmäßig einen Stab aufweist, mit dem es in die Schraubendruckfeder zu deren Halterung koaxial zu ihr eingreift. Die Führungsvorrichtung kann vorzugsweise aus elektrisch isolierendem Kunststoff bestehen oder die Umfangswandung bzw. -wandungen ihrer das oder die Kontaktierglieder aufnehmenden Führung oder Führungen elektrisch isolierende Beschichtungen aufweisen. Die Schraubendruckfeder kann in der Führung im unbelasteten Zustand zweckmäßig nicht vorgespannt sein.

Wenn die Führungsvorrichtung eine Hülse ist, kann sie zweckmäßig nur ein Rohr sein, also beidseitig offen sein. Die von der Schraubenfeder durchdrungene Mündung der Hülse braucht nicht nach innen umgebogen zu sein, sondern kann zumindest denselben lichten Innendurchmesser aufweisen, wie der vorzugsweise kreiszylindrische Bereich der Hülse, in dem sich die Schraubendruckfeder befindet, da diese nicht vorgespannt sein muß. Ein Vorteil ist auch, daß das vordere Ende der Hülse nach außen zur Bildung eines Flansches umgebogen sein kann, was auf einfache Weise herstellbar ist und ermöglicht, daß diese Hülse in eine Aufnahmebohrung einer Platte eines Prüfadapters so eingesetzt sein kann, daß sie mit dem Flansch auf dieser Platte aufsitzt und so für sie keine zusätzliche Befestigung an dieser Platte notwendig ist. Bei dem vorbekannten Federkontaktstift nach der DE-OS 28 52 886 ist dies dagegen nicht möglich, da bei ihm das vordere Ende der Hülse nach innen umgebördelt sein muß.

Das rückwärtige Ende der Schraubendruckfeder kann direkt das Anschlußende des Kontaktiergliedes sein, an das ein elektrischer, zu einem Auswerter oder Testgerät der Prüfeinrichtung weiterführender elektrischer Leiter fest oder lösbar angeschlossen ist oder anschließbar ist, bspw. durch Löten, Andrücken, Einstecken oder dgl.

Es kann in vielen Fällen zweckmäßig vorgesehen sein, daß die Führung an ihrem hinteren Ende einen sie ganz oder teilweise schließenden Boden oder dgl. aufweist. Die Schraubendruckfeder kann dann auf diesem Boden oder dgl. aufsitzen.

Die Schraubenfeder ist so steif und/oder durch einen in sie eingesteckten Stab, vorzugsweise einen Schaft eines Kontaktkopfes des Kontaktelementes versteift, daß ihr über die Führung überstehender Bereich im Ruhezustand in der Betriebsstellung des Kontaktiergliedes gerade und in Fluchtung mit der Führung ist, damit sie beim Prüfen von Prüflingen genau auf die vorgesehene, zu kontaktierende Stelle des jeweiligen Prüflinges auftrifft. Die vorgesehene Betriebsstellung des Kontaktiergliedes ist normalerweise vertikal.

Auch ist die Schraubenfeder des Kontaktiergliedes so steif und/oder durch einen in sie eingesteckten Stab, vorzugsweise einen Schaft eines Kontaktkopfes des Kontaktelmentes versteift, daß ihr über die Führung überstehender Bereich durch die beim Kontaktieren von Prüflingen auf sie einwirkenden Kräfte nicht geknickt wird, sondern gerade bleibt bzw. beim Kontaktieren von zu ihr exzentrischen Bohrungsrändern von Prüflingen sich - schwach biegen kann, ohne zu knicken, so daß sie die von Prüflingen auf sie ausgeübten axialen Kräfte stets ohne zu knicken aushält und so zur Schraubendruckfeder weiterleiten kann. Dabei kann gemäß einer baulich besonders einfachen Ausführungsform der Erfindung vorgesehen sein, daß der Innenraum der Schraubenfeder frei von irgendwelchen anderen Teilen ist. Die Eigensteifigkeit der Schraubenfeder ist dann also so groß vorzusehen, daß sie im Betrieb nicht knickt und in der Betriebsstellung im unbelasteten Zustand gerade und koaxial zur geraden Schraubendruckfeder ist. Es kann jedoch bei einer ebenfalls vorteilhaften Ausführungsform auch vorgesehen sein, sie, wie erwähnt, durch einen Schaft eines Kontaktkopfes, welcher Schaft sich vorzugsweise bis in die Ausnehmung hinein erstrecken kann, oder einen sonstigen in sie eingesteckten Stab zu versteifen.

Erfindungsgemäße Kontaktiervorrichtungen können vorzugsweise folgende Dimensionierungen erhalten:

Das Verhältnis der Länge des über die Führung der Führungsvorrichtung überstehenden Bereiches der unbelasteten Schraubenfeder zu dem maximalen Windungsaußendurchmesser dieses Bereiches kann vorzugsweise mindestens 4 : 1, besonders zweckmäßig mindestens 5 : 1 betragen.

Der Windungsaußendurchmesser der Schraubenfeder kann vorzugsweise mindestens 0,4 mm und/oder vorzugsweise maximal 2 mm, besonders günstig 0,8 - 1,2 mm betragen.

Die Länge des über die Führung der Führungsvorrichtung überstehenden Bereiches der Schraubenfeder in deren unbelastetem Zustand kann vorzugsweise maximal 8 mm und/oder vorzugsweise mindestens 2 mm, besonders zweckmäßig 4 - 6 mm betragen.

Der die Schraubenfeder und die Schraubendruckfeder gemeinsam bildende Federdraht, der vorzugsweise kontanten kreisrunden Querschnitt aufweisen kann, kann vorzugsweise maximal 0,18 mm und/oder vorzugsweise mindestens 0,07 mm, besonders zweckmäßig 0,08 - 0,15 mm betragen.

Wenn eine Hülse vorgesehen ist, können der oder die Außendurchmesser des oder der zylindrischen Bereiche der Hülse vorzugsweise maximal 2,5 mm und/oder vorzugsweise mindestens 0,5 mm, besonders zweckmäßig 0,6 - 1,4 mm betragen.

Die Länge der aus der Schraubendruckfeder und der Schraubenfeder bestehenden Feder (Gesamtfeder) kann vorzugsweise mindestens 1 cm und/oder vorzugsweise maximal 8 cm, besonders zweckmäßig 1,5 bis 6 cm, besonders vorteilhaft 2 bis 5 cm betragen.

Wenn eine Hülse vorgesehen ist, kann deren Wandstärke vorzugsweise maximal 0,25 mm, besonders zweckmäßig 0,1 bis 0,2 mm betragen.

Die Länge der Schraubendruckfeder kann vorzugsweise mindestens 0,8 cm, vorzugsweise 1 bis 5 cm betragen. Im Falle der Ausbildung als Federkontaktstift kann seine Länge vorzugsweise mindestens 1 cm und/oder vorzugsweise maximal 8 cm, besonders zweckmäßig 1,5 bis 6 cm betragen.

In der Zeichnung sind Ausführungsbeispiele der Erfindung dargestellt. Es zeigen:

Fig. 1 einen gebrochenen Längsschnitt durch einen Federkontaktstift gemäß einem Ausführungsbeispiel der Erfindung,

Fig. 2 einen gebrochenen Längsschnitt durch einen Federkontaktstift gemäß einem weiteren Ausführungsbeispiel der Erfindung,

Fig. 3 eine Variante eines Details des Federkontaktstiftes nach Fig. 1,

Fig. 4 einen Schnitt durch eine ausschnittsweise dargestellte Kontaktiervorrichtung gemäß einem weiteren Ausführungsbeispiel der Erfindung.

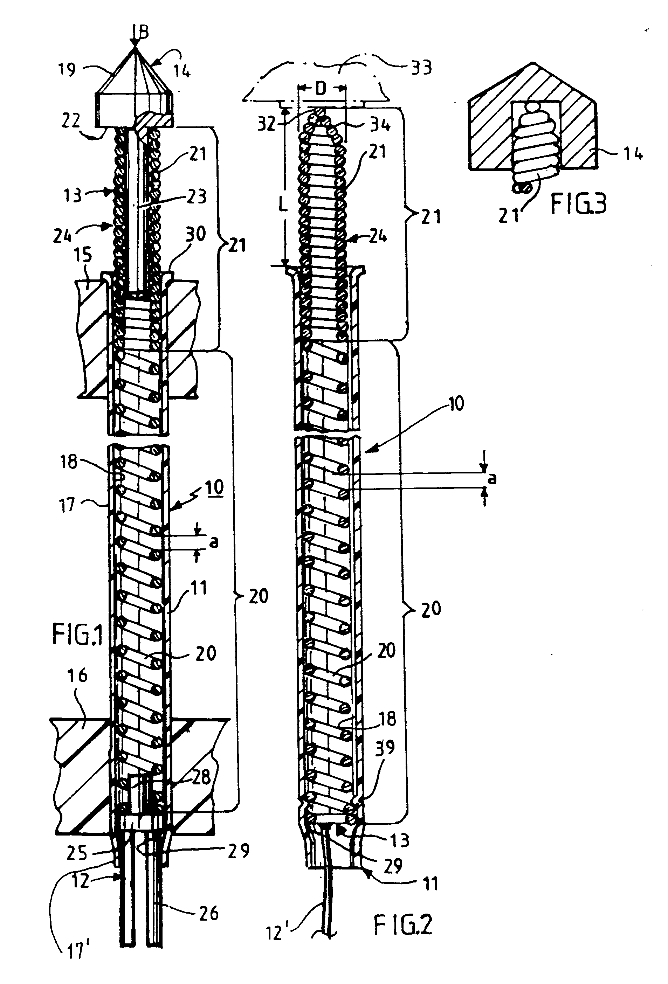

Der in Fig. 1 dargestellte Federkontaktstift 10 bildet eine Kontaktiervorrichtung und besteht aus einer rohrförmigen dünnen rotationssymmetrischen Hülse 11 aus elektrisch isolierendem Kunststoff, deren Außendurchmesser vorzugsweise maximal 1,5 mm betragen kann, im allgemeinen jedoch noch erheblich kleiner sein kann, bspw. auch kleiner als 1 mm sein kann, einem einstückigen metallischen Einsatzstück 12 und einem geraden, dem Kontaktieren von Prüflingen dienenden Kontaktierglied 24, das aus einer einstückigen, geraden, metallischen Feder 13 und einem einstückigen metallischen Kontaktkopf 14 besteht. Die eine Führungs- und Tragvorrichtung für das Kontaktierglied 24 bildende Hülse 11 ist einstückig und in zwei ihrer Halterung dienende Tragplatten 15,16 eines nicht in weiteren Einzelheiten dargestellten Prüfadapters zusammen mit vielen weiteren gleichen Federkontaktstiften 10 eingesetzt, wobei in diesen Prüfadapter ggf. auch noch andere Kontaktstifte zusätzlich eingesetzt sein können, bspw. pneumatische Kontaktstifte. Eine einen Abschnitt der Feder 13 bildende gerade Schraubenfeder 21 und der Kontaktkopf 14 bilden hier zusammen das Kontaktelement dieses Federkontaktstiftes 10, das zwecks genauen Treffens von zu kontaktierenden Stellen von Prüflingen in der Hülse 11 mit geringem Gleitlagerspiel geradegeführt und mittels einer den restlichen Bereich der Feder 13 bildenden, zur Schraubenfeder 21 koaxialen Schraubendruckfeder 20 federnd abgestützt ist, die durch die Hülse 11 ebenfalls geführt und dadurch gegen Ausknicken gesichert und bei unbelastetem Kontaktierglied nicht gespannt ist, da das Kontaktierglied 24 nur rückseitig gehalten oder abgestützt ist.

Der die Feder 13 enthaltende langgestreckte Bereich 17 der Hülse 11 ist wie dargestellt mit Ausnahme des oberen Randflansches 30 zylindrisch, also im wesentlichen zylindrisch, vorzugsweise kreiszylindrisch. Die Hülse verlängert sich danach etwas bis zu einem kurzen zylindrischen unteren Endbereich 17', der im Durchmesser verkleinert ist.

Der Federkontaktstift 10 dient dem Kontaktieren von Prüflingen, bspw. Leiterplatten oder dgl. Der Kontaktopf 14 wird an die durch ihn jeweils zu kontaktierenden Stellen des betreffenden Prüflings angedrückt, um diese Stelle elektrisch mit einem an den Prüfadapter angeschlossenen Auswerter oder Testgerät der betreffenden Prüfvorrichtung zu verbinden, die die Prüflinge auf elektrische Fehlerfreiheit prüft. Dieser Kontaktkopf 14 kann hierzu irgendeine geeignete Ausbildung aufweisen. In diesem Ausführungsbeispiel weist er eine konische Spitze 19 auf, doch kann er auch andere geeignete Ausbildungen haben, bspw. mit Schneiden versehen sein, nadelförmig sein oder dgl. Dieser Kontaktkopf 14 ist aud die Feder 13 aufgesteckt, die jetzt näher beschrieben wird.

Die aus einem einzigen Runddraht - ggf. kann auch ein Profildraht mit unrundem, bspw. rechteckförmigem Profil vorgesehen sein - gewickelte Feder 13 besteht aus zwei unterschiedlich gewickelten Abschnitten. Ihr Längsabschnitt 20 bildet eine zylindrische Schraubendruckfeder, die axial stark zusammendrückbar ist, indem ihre Windungen sich nicht berühren, sondern im entspannten Zustand so viel Abstand a voneinander haben, daß sich der gewünschte Federweg und die für das Kontaktieren des Prüflings jeweils erforderliche Federkraft beim hierbei stattfindenden Zusammendrücken ergeben. Der Abschnitt 21 dieser Feder 13 bildet eine axial nicht zusammendrückbare zylindrische Schraubenfeder, indem ihre Windungen in diesem Ausführungsbeispiel im Ruhezustand mit oder ohne Vorspannung aneinander anliegen. Wie dargestellt, hat die Schraubenfeder 21 ungefähr denselben Windungsdurchmesser wie die Schraubendruckfeder 20, so daß die aus ihnen bestehende Gesamtfeder eine ungefähr zylindrische Schraubenfeder 13 ist, vorzugsweise eine zylindrische Schraubenfeder ist. Unter Windungsdurchmesser versteht man den mittleren Windungsdurchmesser. Im Hinblick auf den konstanten Drahtquerschnitt ergibt sich jedoch, daß, wenn die mittleren Windungsdurchmesser unter sich ungefähr gleich groß sind, daß dann auch die äußeren Windungsdurchmesser (= Windungsaußendurchmesser) unter sich ebenfalls ungefähr gleich groß sind. Es kann in manchen Fällen auch vorgesehen sein, daß die Windungen der Schraubenfeder 21 geringen Abstand voneinander haben, der kleiner als a ist, damit diese Schraubenfeder 21 den Schaft 23 des Kontaktkopfes 14 halten kann. Die Windungszahl/cm (also die Anzahl der Windungen pro Zentimeter Federlänge) ist für die Schraubenfeder 21 also größer als für die Schraubendruckfeder 20. Auch das Verhältnis Z/D, wo Z = Windungsanzahl/cm und D = Windungsaußendurchmesser bedeutet, ist für die Schraubenfeder 21 wesentlich größer also für die Schraubendruckfeder 20, da D für die Federn 20 und 21 gleich groß oder annähernd gleich groß ist, nicht jedoch Z, denn Z ist für die Schraubenfeder 21 größer, vorzugsweise wesentlich größer als für die Schraubendruckfeder 20. Die Eigensteifigkeit der Schraubenfeder 21 ist so groß und/oder sie wird durch den in sie reibungsschlüssig eingesteckten Schaft 23 so versteift, daß sie bei der Prüfung von Prüflingen nicht knicken kann, wenn die Feder 13 dabei durch in Richtung des Pfeiles B auf den Kontaktkopf ausgeübte Druckkräfte belastet wird und damit sie auch durch das Gewicht des Kontaktkopfes 14 in ihrer unbelasteten Betriebsstellung nicht gebogen wird.

Der Bereich 21 der Feder 13 sei als Schraubenfeder und der Bereich 20 als Schraubendruckfeder bezeichnet, um diese beiden Bereiche unterschiedlich zu benennen. Die Schraubenfeder 21 führt vom vorderen Ende der Feder 13, das an einem Ringbund 22 des Kontaktkopfes 14 anliegt, in entspanntem Zustand der Feder 13 bereits ein kurzes Stück weit axial in die rohrförmige Hülse 11 wie dargestellt hinein, damit diese Schraubenfeder 21 in der Hülse 11 so geführt ist, daß ihre Längsachse koaxial zur Hülse 11 verläuft. Der jeweils in der Hülse 11 befindliche Bereich der Schraubenfeder 21 bildet praktisch einen Kolben, da er in der Hülse 11 mit geringem Gleitlagerspiel geführt ist. Sein Außendurchmesser ändert sich nicht, so daß gleichbleibend gute Führung dieses "Kolbens" in der durch ihren Innenraum 18 gebildeten Führung der Hülse 11 gewährleistet ist. Dieser "Kolben" ist jedoch nicht starr, sondern biegsam und ergibt so besonders gute Anpassung an die Hülse 11 auch dann, wenn diese sich etwas biegen sollte. Die Schraubendruckfeder 20 kann denselben Windungsaußendurchmesser wie die Schraubenfeder 21 erhalten, wenn für sie nicht die Gefahr besteht, daß sie durch ihr beim Zusammendrücken entstehendes geringfügiges Aufweiten sich an die Innenwand der Hülse 11 störend andrückt. Besteht letztere Gefahr, kann ihr Windungsaußendurchmesser geringfügig kleiner als der Windungsaußendurchmesser der Schraubenfeder 21 gemacht werden. Würde die Schraubenfeder 21 nicht in die Hülse 11 hineinragen oder nur sehr wenig, dann bestünde die Gefahr, daß sie infolge der Schraubendruckfeder 20 aus ihrer mit der Hülse 11 fluchtenden Lage durch das Eigengewicht bzw. das Gewicht des Kontaktkopfes 14 herausgelangen kann und dann kein präzises Kontaktieren der durch diesen Federkontaktstift zu kontaktierenden Stellen von Prüflingen mehr möglich wäre. Andererseits ermöglicht diese Schraubenfeder 21 jedoch, wie bereits dargelegt, daß beim exzentrischen Auftreffen des Kontaktkopfes 14 auf einen zu kontaktierenden Bohrungsrand einer Leiterplatte oder dgl. sich dieser Kopf 14 unter entsprechendem geringem Biegen der Schraubenfeder 21 und ggf. des sehr dünnen Schaftes 23, der vorzugsweise aus elastischem Metall besteht, zu diesem Bohrungsrand ohne Beschädigungsgefahr des Federkontaktstiftes 10 zentrieren kann.

Die Schraubenfeder 21 ist in den Ausführungsbeispielen erheblich kürzer als die Schraubendruckfeder 20. Der im unbelasteten Zustand über die Hülse 11 überstehende Bereich der Länge L der Schraubenfeder 21 ist mehrfach größer als der maximale Außendurchmesser D (Fig. 2) dieses überstehenden Bereiches. Vorzugsweise kann L/D mindestens 4 : 1, besonders zweckmäßig mindestens 5 : 1 betragen.

Der Kontaktkopf 14 weist in diesem Ausführungsbeispiel den zylindrischen Schaft 23 auf, der in die Schraubenfeder 21 eingesteckt ist und sie hierdurch etwas aufgeweitet hat, so daß hierdurch der Kontaktkopf 14 reibungsschlüssig an der Schraubenfeder 21 gehalten ist. Dabei ist es besonders günstig, wenn, wie dargestellt, im entspannten Zustand der Schraubendruckfeder 20 dieser Schaft 23 noch ein kurzes Stück in die Hülse 11 hineinragt, wodurch der Schaft 23 die Schraubenfeder 21 besonders gut zusätzlich versteifen kann. Der im Bereich der Feder 13 konstante Innendurchmesser der Hülse 11 ist geringfügig größer als der Außendurchmesser, d.h. der Windungsaußendurchmesser der Feder 13, derart, daß die Feder 13 auf ihrem sich jeweils innerhalb des betreffenden kreiszylindrischen Bereichs der Hülse 11 befindlichen Bereich durch die Hülse 11 geführt ist, wobei diese Feder 13 jedoch mit Ausnahme ihres unteren, gehaltenen Endes in der Hülse mit geringem Gleitlagerspiel auch dann noch gleiten kann, wenn die Schraubendruckfeder 20 durch das Kontaktieren von Prüflingen entsprechend zusammengedrückt ist.

Der Schaft 23 versteift die Schraubenfeder 21, so daß sie auch unter extremen Bedingungen nicht knicken kann. Auch erlaubt der Schaft 23, daß die Feder 13 aus besonders dünnem Draht gewickelt werden kann.

Das rückwärtige Ende der Schraubendruckfeder 20 liegt an einem Auflager an, das als Ringbund 25 des Einsatzstückes 12 ausgebildet ist. Der Ringbund 25 liegt an einer durch eine Verringerung des Durchmessers des Innenraumes 18 der Hülse 11 gebildeten Innenschulter 29 der Hülse 11 an und ragt mit einem rückwärtigen, geschlitzten Fuß 26 durch den zylindrischen, im Durchmesser verkleinerten rückwärtigen Endbereich 17' der Hülse sich hier durch Reibung selbsthaltend hindurch. Auf der anderen Seite des Ringbundes 25 ist ein stiftförmiger Vorsprung 28 angeordnet, auf den die Schraubendruckfeder 20 sich auf ihm durch Reibung selbsthaltend aufgesteckt ist. Damit hält sich das Einsatzstück 12 nur durch Reibung in der Hülse 11 und die Feder 13 wiederum ebenfalls nur durch Reibung auf dem Einsatzstück 12, und der Kontaktkopf 14 hält sich ebenfalls nur mit Reibung auf der Schraubenfeder 21, so daß diese Teile lösbar miteinander verbunden sind und leicht und rasch zum fertigen Federkontaktstift zusammengesteckt und auch wieder auseinander genommen werden können, bspw. zwecks Auswechseln eines beschädigten Teiles.

Das aus der Hülse herausragende Einsatzstück 12 kann als elektrischer Anschluß dieses Federkontaktstiftes 10 dienen, indem bspw. an ihn ein weiterführender elektrischer Leiter angeschlossen, z.B. angelötet ist. Es ist auch möglich, einen solchen weiterführenden Leiter in eine Bohrung des Einsatzstückes 12 einzusetzen u.s.w. Das Kontaktierglied 24 bildet bei der Prüfung eines Prüflinges einen diesen kontaktierenden elektrischen Leiter, der innerhalb der Hülse 11 durch diese umfangsseitig elektrisch isoliert und über das Einsatzstück 12 und einen an diesen angeschlossenen weiterführenden elektrischen Leiter mit dem Auswerter oder dem Testgerät der betreffenden Prüfvorrichtung verbunden ist. Alle Federkontaktstifte des betreffenden Prüfadapters sind dabei gegeneinander elektrisch isoliert, was bei diesen Federkontaktstiften 10 schon durch ihre elektrisch isolierenden Hülsen 11 bewirkt wird.

Die Hülse 11 ist am vorderen Ende zu einem schmalen Ringflansch 30 aufgeweitet, welcher an der Vorderseite der vorderen Platte 15 des Prüfadapters anliegt, so daß dieser Federkontaktstift 10 hierdurch gegen die auf ihn beim Prüfen von Prüflingen in Richtung des Pfeiles B einwirkenden Kräften abgestützt ist und es hierzu keiner sonstigen anderen Maßnahmen bedarf.

Dieser Federkontaktstift 10 ist kostengünstig herstellbar, weist nur wenige rasch und einfach zu montierende Teile auf und läßt sich auch gewünschtenfalls wieder in seine Einzelteile zwecks Austauschens von beschädigten Teilen zerlegen. Auch kann der Kontaktkopf 14 gegen andere Kontaktköpfe ausgewechselt werden. Der Federkontaktstift 10 ist wegen der Möglichkeit des Biegens der Schraubenfeder 21 beim Kontaktieren von Prüflingen nicht mehr der Beschädigungsgefahr wie die bekannten Federkontaktstifte mit starren Kolben ausgesetzt. Auch ist bei der Herstellung dieses Federkontaktstiftes keine einwärtige Bördelung an der Hülse vorzunehmen.

Der ebenfalls eine Kontaktiervorrichtung bildende Federkontaktstift 10 nach Fig. 2 unterscheidet sich von dem nach Fig. 1 einmal dadurch, daß sein Kontaktierglied 24 ausschließlich aus einer einzigen Feder 13 besteht, deren einen Längsbereich von ihr bildenden Schraubenfeder 21 sich am vorderen Endbereich 34 kegelförmig verjüngt, wogegen ihr anderer Längsbereich die nicht vorgespannte Schraubendruckfeder 20 bildet. Das vordere Ende 32 der metallischen, geraden Feder 13 bildet die dem Inkontaktkommen mit Prüflingen 33 deinende Kontaktspitze dieses Federkontaktstiftes 10 wie dargestellt. Um dies besonders deutlich zu zeigen, ist in Fig. 2 ein Prüfling 33 strichpunktiert mit eingezeichnet, wie er gerade in Kontakt mit dieser Kontaktspitze 32 kommt. Die Eigensteifigkeit der hier nicht durch einen Schaft versteiften Schraubenfeder 21 ist so groß, daß ihr über die aus elektrisch isolierendem Kunststoff oder sonstigem elektrisch isolierendem Material, wie Keramik oder dgl., bestehenden Hülse 11 überstehender Bereich zumindest in der vorgesehenen Betriebsstellung des Federkontaktstiftes 10 im unbelasteten Zustand gerade und in Fluchtung mit der Hülse 11 ist und ihm die für die Prüfung von Prüflingen, wie 33, ausreichende Knickfestigkeit gegeben ist, so daß dieser überstehende Bereich im Betrieb nicht knicken kann. Auch kann der Windungsaußendurchmesser des konstanten Windungsaußendurchmesser aufweisenden Bereichs der Schraubenfeder 21 gleich oder nahezu gleich dem konstanten Windungsaußendurchmesser der zu ihr koaxialen Schraubendruckfeder 20 sein.

Man kann jedoch auch vorsehen, auf den vorderen Bereich der Schraubenfeder 21 einen gesonderten metallischen Kontaktkopf 14 aufzustecken, wie es Fig. 3 an einem Ausführungsbeispiel zeigt. In Fig. 3 ist nur der vordere Endbereich der Feder 13 des nicht in weiteren Einzelheiten dargestellten Federkontaktstiftes dargestellt.

Dieser Kontaktkopf 14 in Fig. 3 kann vorzugsweise auch nur lösbar auf der Schraubenfeder 21 gehalten sein, oder er kann auch bspw. durch Laserschweißen mit der Schraubenfeder 21 fest verbunden sein.

Der in Fig. 2 dargestellte Federkontaktstift 10 unterscheidet sich von dem nach Fig. 1 ferner noch dadurch, daß das Einsatzstück 12 weggelassen und an seiner Stelle die Schraubendruckfeder 20 direkt auf der Innenschulter 29 des beidseits offenen, die Führung oder Ausnehmung 18 dieser rohrförmigen Hülse 11 bildenden Innenraumes dieser Hülse 11 aufsitzt. Diese Schraubendruckfeder 20 kann hier bspw. dadurch gehalten werden, indem ihr rückwärtiges Ende in die Hülse 11 eingeklebt ist. Oder sie kann formschlüssig gehalten sein, indem die Hülse 11 über der untersten Windung der Feder 13 eine nach innen gerichtete Einsenkung 19 aufweist, die diese Feder 13 am unteren Ende festhält.

In dem Ausführungsbeispiel nach Fig. 2 ist ferner an das untere Ende der Schraubendruckfeder 20 ein elektrischer Leitungsdraht 12' angelötet oder angeschweißt, der zu dem nicht dargestellten Testgerät oder Auswerter der betreffenden Prüfvorrichtung führt.

In dem Ausführungsbeispiel nach Fig. 2 bildet die Schraubenfeder 21 allein das Kontaktelement dieses Federkontaktstiftes 10. Dagegen wird bei den Ausführungsformen nach den Fig. 1 und 3 das Kontaktelement des betreffenden Federkontaktstiftes jeweils durch die Schraubenfeder 21 und den auf ihr angeordneten Kontaktkopf 14 gebildet.

Man kann auch bei einem Kontaktkopf 14 nach Fig. 3 vorsehen, in der Schraubenfeder 21 einen sie versteifenden Stab reibungsschlüssig einzustecken, bspw. vom freien Ende der Schraubendruckfeder 20 aus oder vom freien Ende der Schraubenfeder 21 aus, das dann zylindrisch und nicht wie dargestellt konisch auszubilden ist.

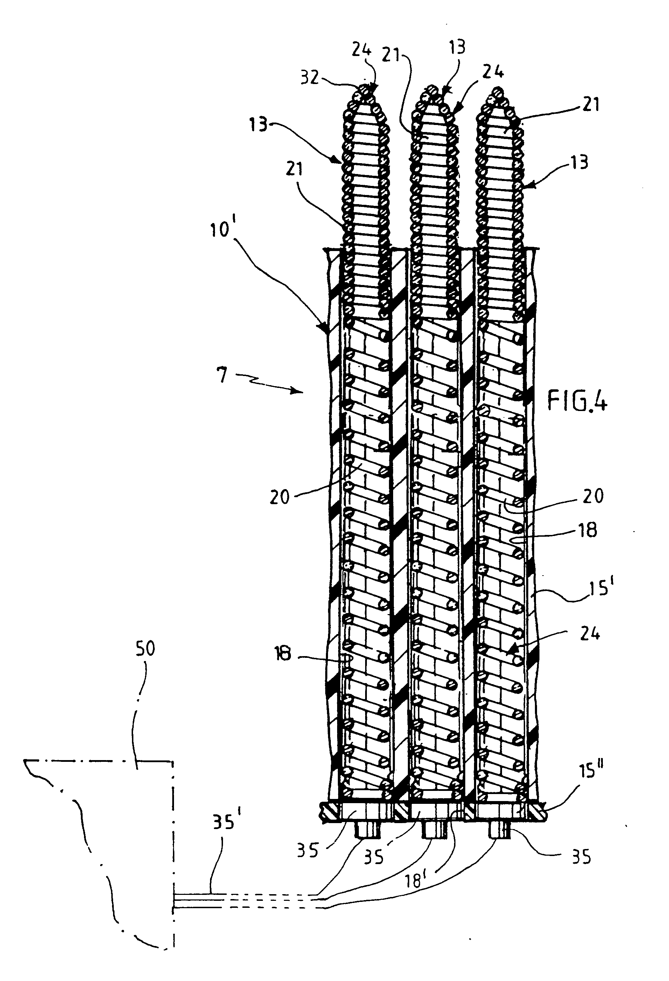

In Fig. 4 ist eine Kontaktiervorrichtung 10' ausschnittsweise dargestellt, die kein einzelner Federkontaktstift ist, sondern eine Führungs- und Tragvorrichtung 7 für eine Vielzahl von zueinander parallel angeordneten Kontaktiergliedern 24 eines nicht in weiteren Einzelheiten dargestellten Prüfadapters bildet. Diese Führungs- und Tragvorrichtung 7 weist zwei zueinander parallele, aneinander anliegende und lösbar miteinander verbundene Platten 15', 15" aus elektrisch isolierendem Kunststoff auf, von denen die Platte 15' der seitlichen Führung der Kontaktierglieder 24 dient. Die Platte 15" enthält mit den Bohrungen 18 der Führungsplatte 15' fluchtende Bohrungen 18', in die metallische Anschlußkontakte 35 fest eingesetzt sind, an denen die rückwärtigen Enden der Schraubendruckfedern 20 der Kontaktierglieder 24 in elektrischem Kontakt mit ihnen anliegen. Diese Platten 15',15" und die Kontaktierglieder 24 sind also Teile eines nicht in weiteren Einzelheiten dargestellten Prüfadapters mit einer vorzugsweise großen Anzahl von kontaktiergliedern 24, die in die Führungen für sie bildenden Bohrungen oder Ausnehmungen 18 der Platte 15' parallel zueinander eingesetzt sind. Die aus elektrisch isolierendem Kunststoff bestehenden Wandungen dieser Bohrungen 18,18' isolieren also die in sie eingesetzten Kontaktierglieder 24 und die Anschlußkontakte 35 umfangsseitig elektrisch, so daß die Bohrungen 18,18' sehr geringe Seitenabstände voneinander haben können ohne Gefahr elektrischen Kurzschlusses zwischen benachbarten Kontaktiergliedern 24. Von den Kontaktiergliedern 24 sind nur drei dargestellt, doch kann ihre Anzahl beliebig groß sein. Sie sind unter sich gleich ausgebildet, und zwar in diesem Ausführungsbeispiel wie das Kontaktierglied 24 der Fig. 2, das also in diesem Ausführungsbeispiel aus einer geraden, einstückigen Feder 13 besteht, die aus den zueinander axialen, die Schraubendruckfeder 20 und die Schraubenfeder 21 bildenden Bereichen besteht. Die Führungen 18 der eine Führungsvorrichtung für die Kontaktierglieder bildenden oder mitbildenden Platte 15', in die die Federn 13 nur mit Bereichen ihrer Schraubenfedern 21 aus ihnen herausragend eingesetzt sind, sind zueinander parallele, kreiszylindrische, sehr nahe nebeneinander angeordnete Bohrungen, so daß die Schraubendruckfedern 20 auch in diesem Ausführungsbeispiel nicht vorgespannt sind. Die Federn 13 sind an den Anschlußkontakten 35 abgestützt oder sie können in manchen Fällen auch durch Löten oder Schweißen oder dgl. mit ihnen unlösbar oder vorzugsweise lösbar verbunden sein. In den Bohrungen 18 sind die Schraubenfedern 21 der Gesamtfedern 13 mit geringem Gleitlagerspiel geradegeführt und auch die Schraubendruckfedern 20 geführt und dadurch gegen seitliches Ausknicken geschützt. Die Umfangswandungen der durch die Bohrungen 18 gebildeten Führungen isolieren die Kontaktierglieder 24 gegeneinander. Es sind also die Innenumfangswandflächen der Führungen 18, die die Kontaktierglieder 24 umfassen und nicht deren elektrischem Anschluß dienen, zu deren umfangsseitiger elektrischer Isolation ausgebildet, wodurch diese Kontaktierglieder 2 gegeneinander elektrisch isoliert sind.

Oder die Federn 13 können in nicht dargestellten Weise an im Abstand von der Platte 15' am Prüfadapter angeordneten Kontakten oder dgl. abgestützt oder befestigt sein, so daß dann die Platte 15' und solche Halte- oder Widerlagerteile als Führungs- und Tragvorrichtung für die Kontaktglieder 24 dienen.

An den Anschlußkontakten 35 sind weiterführende elektrische Leiter, bspw. Leitungsdrähe 35' angeordnet, die zu einem Auswerter oder Testgerät 50 der einen solchen Prüfadapter aufweisenden Prüfeinrichtung zum Prüfen von elektrischen, vorzugsweise elektronischen Prüflingen, wie Leiterplatten oder dgl.führen. Es ist auch möglich, die Anschlußkontakte 35 wegzulassen und die Federn 13 andersweit abzustützen oder zu befestigen, bspw. direkt an der Kunststoffplatte 15" abzustützen oder zu halten, und an ihre rückwärtigen Enden die Leiter 35' direkt anzuschließen. Die Federn 13 können auch bspw. in den Bohrungen 18 der dann dem Führen und Tragen der Kontaktierglieder 24 dienenden Platte 15' bspw. dadurch abgestützt oder gehalten sein, indem sie mit ihren unteren Enden auf unteren Ringschultern oder dgl. aufsitzen oder in Verengungen eingeklemmt sind, die in die Bohrungen 18 mit eingearbeitet sind, u.s.w.

Wenn die Kontaktierglieder 24 in den Führungen 18 oder auf den Anschlußkontakten 35 oder auf sonstige Weise nur lose abgestützt sind, müssen im Betrieb ihre vorderen Enden 32 nach oben gerichtet sein, damit sie nicht aus den Führungen 18 herausfallen. Diese Anordnung hat den großen Vorteil extrem einfachen Einsetzens und Herausnehmens der Kontaktierglieder 24 in die Führungen Bzw. aus ihnen.

Die Kontaktierglieder 24 können, falls erwünscht, natürlich ebenfalls noch gesonderte Kontaktköpfe aufweisen oder ihre dargestellten vorderen Enden 32 können dem Inkontaktkommen mit den Prüflingen dienen.

Die Platte 15' kann auch mehrschichtig oder mehrteilig sein oder es können ein oder mehrer solche aus Kunststoff bestehenden Platten parallel zueinander ohne oder in Abständen voneinander am Prüfadapter angeordnet sein. Bspw. kann die Platte 15' in vielen Fällen in nicht dargestellter Weise eine obere Schicht oder Platte aufweisen, die Bohrungen zur guten Führung der Schraubenfeder 21 mit engem Spiel aufweist, und eine oder mehrere andere Schichten oder Platten können zusätzlich ohne oder mit Abständen voneinander oder zur anderen Platte vorgesehen sein, die im Durchmesser vorzugsweise etwas größere Bohrungen für die Schraubendruckfeder 20 und ggf. in sie hineinragende Bereiche der Schraubenfedern 21 aufweisen.

Die Federn 13 können aus irgenwelchen geeigneten metallischen Werkstoffen bestehen, vorzugsweise aus Federstahl, Klaviersaitendraht, rostfreiem Stahl, Nickel-Beryllium oder Kupfer-Beryllium. Der die Feder 13 bildende Draht kann vorzugsweise konstanten kreisrunden Querschnitt, oft zweckmäßig auch nicht kreisrunden Querschnitt, bspw. rechteckigen Querschnitt aufweisen.

Als Kunststoffe für die Hülse 11 (Fig. 1,2) bzw. die Platten 15,16,15',15" kommen irgendwelche geeigneten Kunststoffe infrage, vorzugsweise solche mit hoher Festigkeit, bspw. Polyoxymethylen (Delrin), Polyimid, Polytetrafluoräthylen, Polyäthylen, Epoxidharze, polymerer Methacrylsäuremethylester (Plexiglas), u.s.w., wobei besonders günstig solche Kunststoffe vorgesehen sein können, die hohe Verschleißfestigkeit aufweisen und/oder mit den Federn 13 geringe Gleitreibungskoeffizienten ergeben.

## Ansprüche

1. Kontaktiervorrichtung für eine Prüfvorrichtung zum Prüfen von elektrischen oder elektronischen Prüflingen, wie Leiterplatten, sonstigen elektrischen Bauelementen oder dgl., welche Kontaktiervorrichtung mindestens eine metallische, gerade Schraubendruckfeder aufweist, die der axialen Federung eines in einer Führung einer Führungsvorrichtung geradegeführten metallischen kontaktelementes dient, das über diese Führung in Richtung auf den jeweils zu prüfenden Prüfling übersteht und ein dem Kontaktieren des jeweiligen Prüflings dienendes freies Kontaktende aufweist, dadurch gekennzeichnet, daß das Kontaktelement eine an die gerade Schraubendruckfeder (20) einstückig und axial anschließende, also aus demselben Draht wie die Schraubendruckfeder (20) gewickelte metallische Schraubenfeder (21) aufweist, die über die sie führende Führung (18) der Führungsvorrichtung (11;15') übersteht und deren Windungszahl/cm derart größer als die Windungszahl/cm der Schraubendruckfeder (20) ist, daß der über die sie führende Führung (18) der Führungsvorrichtung (11;15') überstehende Bereich dieser Schraubenfeder (21) in der vorgesehenen Betriebsstellung des Kontaktelementes im unbelasteten Zustand gerade und in Fluchtung mit dieser Führung (18) der Führungsvorrichtung ist und ihm für die Prüfung von Prüflingen ausreichende Knickfestigkeit durch ensprechend große Eigensteifigkeit dieser Schraubenfeder (21) und/oder durch einen in sie eingesteckten Stab (23) gegeben ist, so daß das Kontaktelement (21;14,21) und die Schraubendruckfeder (20) ein ein gemeinsames Bauteil bildendes Kontaktierglied (24) bilden, und daß die Innenumfangswandfläche oder -flächen der Führung (18), die das Kontaktierglied (24) umfassen und nicht dessen elektrischem Anschluß dienen, zu dessen umfangsseitiger elektrischer Isolation ausgebildet sind.

2. Kontaktiervorrichtung nach Anspruch 1, dadurch gekennzeichnet, daß die das Kontaktierglied (24) umfassende Umfangswandung bzw. -wandungen der Führung (18), vorzugsweise die ganze Führungsvorrichtung (11;15') aus elektrisch isolierendem Material, vorzugsweise aus Kunststoff besteht bzw. bestehen.

3. Kontaktiervorrichtung nach Anspruch 1 oder 2, dadurch gekennzeichnet, daß die Länge des über die Führung (11;15') überstehenden Bereichs der Schraubenfeder (21) zumindest in umbelastetem Zustand größer als der maximale Durchmesser dieses Bereiches ist und/oder daß die Windungen der Schraubenfeder (21) im unbelasteten Zustand der Kontaktiervorrichtung (24) aneinander anliegen und/oder daß die Schraubenfeder (21) und die Schraubendruckfeder (20) zusammen allein das Kontaktierglied (24) bilden.

4. Kontaktiervorrichtung nach Anspruch 1, 2 oder 3, dadurch gekennzeichnet, daß auf dem freien Endbereich der Schraubenfeder (21) ein metallischer Kontaktkopf (14) angeordnet ist, der dem Inkontaktkommen mit dem jeweils zu prüfenden Prüfling dient, wobei vorzugsweise der Kontaktkopf (14) einen in die Schraubenfeder eingesteckten und in ihr vorzugsweise reibungschlüssig gehaltenen Schaft (23) oder eine Bohrung, in die die Schraubenfeder (21) eingesetzt ist, aufweisen kann.

5. Kontaktiervorrichtung nach einem der vorhergehenden Ansprüche, dadurch gekennzeichnet, daß die Führungsvorrichtung mindestens eine Platte (15') aufweist oder aus ihr besteht, die eine Mehr- oder Vielzahl von vorzugsweise durch Bohrungen oder Löcher gebildete Führungen (18) mit in sie eingesetzten, vorzugsweise zueinander parallel angeordneten Kontaktiergliedern (24) aufweist, wobei vorzugsweise mit dieser Platte (15') eine andere Platte (15"), die von den rückwärtigen Enden der Schraubendruckfeden (20) der Kontaktierglieder (24) kontaktierte Anschlußkontakte (35) trägt, ohne oder im Abstand von ihr vorzugsweise lösbar angeordnet ist, welche Platte oder Platten vorzugsweise aus elektrisch isolierendem Material, insbesondere aus Kunststoff bestehen können.

6. Kontaktiervorrichtung nach einem der Ansprüche 1 bis 4, dadurch gekennzeichnet, daß die Führungsvorrichtung eine Hülse (11) aus elektrisch isolierendem Material, vorzugsweise aus Kunststoff aufweist oder aus ihr besteht, in die das Kontaktierglied (24) aus ihr herausragend eingesetzt ist, vorzugsweise diese Kontaktiervorrichtung einen Federkontaktstift (10) bildet.

7. Kontaktiervorrichtung nach einem der vorhergehenden Ansprüche, dadurch gekennzeichnet, daß in der Führung (18) der Führungsvorrichtung ein Auflager (12) für die Schraubendruckfeder angeordnet ist, das vorzugsweise einen in die Schraubendruckfeder (20) zu deren Halterung hineinragenden, stabförmigen Ansatz (28) aufweist und/oder daß die Schraubendruckfeder (20) oder ihr Auflager auf einer durch eine Verengung der Führung gebildeten Innenschulter (29) aufsitzt und daß das Auflager vorzugsweise aus Metall zum elektrischen Anschluß des Kontaktiergliedes (24) besteht.

8. Kontaktiervorrichtung nach einem der vorhergehenden Ansprüche, dadurch gekennzeichnet, daß die Windungen der Schraubenfeder (21) am vorderen Endbereich (34) mit sich in Richtung auf ihr freies Ende zu verringerndem Radius gewickelt sind und der übrige Bereich der Schraubenfeder (21) vorzugsweise konstanten Windungsdurchmesser aufweist, der vorzugsweise dem konstanten Windungsdurchmesser der Schraubendruckfeder (20) entspricht oder ungefähr entspricht.

9. Kontaktiervorrichtung nach einem der vorhergehenden Ansprüche, dadurch gekennzeichnet, daß die Schraubendruckfeder (20) an ihrem rückwärtigen Ende in der Führungsvorrichtung (11;15') und/oder in einer ihr zugeordneten Halte- oder Stützvorrichtung 15" gehalten oder abgestützt ist.

10.Kontaktiervorrichtung nach einem der vorhergehenden Ansprüche, dadurch gekennzeichnet, daß zumindest der in der Führung (18) der Führungsvorrichtung befindliche Bereich der Schraubenfeder (21) und der bewegliche Bereich der Schraubendruckfeder (20) in der zugeordneten Führung (18), vorzugsweise in einem kreiszylindrischen Bereich von ihr mit geringem Seitenspiel geführt sind.

11.Kontaktiervorrichtung nach einem der vorhergehenden Ansprüche, dadurch gekennzeichnet, daß der Windungsdurchmesser der Schraubendruckfeder (20) über ihre Länge ungefähr konstant ist, und daß der Windungsdurchmesser der Schraubenfeder (21) ebenfalls ungefähr konstant oder nahezu über ihre Länge ungefähr konstant ist und zumindest der Windungsdurchmesser des in der Führung (18) befindlichen Bereichs der Schraubenfeder (21) ungefähr dem Windungsdurchmesser der Schraubendruckfeder (20) entspricht.

12.Kontaktiervorrichtung nach einem der vorhergehenden Ansprüche, dadurch gekennzeichnet, daß die vordere Mündung der Führung (18) unverengt ist und/oder daß die Hülse (11) vorzugsweise einen nach außen gerichteten Ringflansch (30) aufweist und/oder daß der Schaft (23) des Kontaktkopfes (14) sich im unbelasteten Zustand des Kontaktelementes (14;21) bis in die Führung (18) hineinerstreckt und/oder daß die aus der Schraubendruckfeder (20) und der Schraubenfeder (21) bestehende Feder (13) ggf. mit Ausnahme des freien Endbereiches (34) der Schraubenfeder (21) ungefähr konstanten Windungsaußendurchmesser aufweist.

13. Kontaktiervorrichtung nach einem der vorhergehenden Ansprüche, dadurch gekennzeichnet, daß das Verhältnis der Länge des über die zugeordnete Führung (18) der Führungsvorrichtung (11;15') überstehenden Bereichs der unbelasteten Schraubenfeder (21) zu dem maximalen Windungsaußendurchmesser dieses Bereiches mindestens 4 : 1, vorzugsweise mindestens 5 : 1 beträgt, und/oder daß der Windungsaußendurchmesser der Schraubenfeder (21) maximal 2 mm und/oder vorzugsweise mindestens 0,4 mm beträgt, und/oder daß die Länge des über die zugeordnete Führung (18) der Führungsvorrichtung (11;15') überstehenden Bereichs der Schraubenfeder (21) in deren unbelastetem Zustand maximal 8 mm und/oder vorzugsweise mindestens 2 mm beträgt, und/oder daß der Durchmesser des die Schraubenfeder (21) und die Schraubendruckfeder (20) bildenden Federdrahtes, der vorzugsweise kreisrunden Querschnitt aufweist, maximal 0,18 mm, vorzugsweise 0,08 - 0,15 mm beträgt, und/oder daß der oder die zylindrischen Bereiche der Hülse (11) Außendurchmesser von maximal 2,5 mm und/oder von mindestens 0,5 mm, besonders zweckmäßig von 0,6 bis 1,4 mm aufweist bzw. aufweisen, und/oder daß die Länge der aus der Schraubendruckfeder (20) und der Schraubenfeder (21) bestehenden Feder (13) mindestens 1 cm und/oder maximal 8 cm, besonders zweckmäßig 1,5 bis 5cm beträgt, und/oder daß die Wandstärke der Hülse (11) maximal 0,25 mm, vorzugsweise 0,1 - 0,2 mm beträgt, und/oder daß die Länge der Schraubendruckfeder (20) mindestens 0,8 cm, vorzugsweise 1 - 5 cm beträgt, und/oder daß die Länge eines die Hülse mit einem zugeordneten Kontaktierglied aufweisenden Federkontaktstiftes (10) mindestens 1 cm und/oder max. 8 cm, besonders zweckmäßig 1,5 - 6 cm beträgt.

0 292 590

FIG.1

FIG.2

FIG.3

FIG.4

Europäisches
Patentamt

**EUROPÄISCHER RECHERCHENBERICHT**

Nummer der Anmeldung

EP  87 10 7679

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| Y | DE-A-3 500 227  (RIBA PRÜFTECHNIK) <br> * Ansprüche 2-4; Figur 1, Seite 6, Absatz 3 - Seite 10, Absatz 2 * | 1 | G 01 R    1/067 |
| A |  | 3-12 |  |
|  | --- |  |  |
| Y | US-A-3 500 191  (E.E. GICK) <br> * Spalte 2, Zeile 34 - Spalte 3, Zeile 18; Figur 2 * | 1 |  |
| A |  | 2 |  |
|  | --- |  |  |
| A | DE-A-3 340 431  (FEINMETALL) <br> * Zusammenfassung; Figur * | 1 |  |
|  | --- |  |  |
| A | DE-A-3 300 247  (TECHNOBAL) <br> * Zusammenfassung; Figuren 2, 3 * | 1 |  |
|  | --- |  |  |
| A | DE-A-3 038 937  (TERADYNE) <br> * Figur 1 * | 1,13 |  |
|  | --- |  |  |
| A | US-A-4 029 375  (H. GABRIELIAN) <br> * Zusammenfassung; Figur 1 * | 1 | **RECHERCHIERTE SACHGEBIETE (Int. Cl.3)** |
|  | --- |  |  |
| A,D | DE-A-2 852 886  (FEINMETALL) <br> * Seiten 3, 4 * <br> ----- |  | G 01 R    1/067 <br> G 01 R    1/073 <br> H 01 R   11/18 <br> H 01 R   23/72 |

Der vorliegende Recherchenbericht wurde für alle Patentansprüche erstellt

| Recherchenort | Abschlußdatum der Recherche | Prüfer |
|---|---|---|
| BERLIN | 12-01-1988 | LEMMERICH J |